Europäisches Patentamt

European Patent Office

Office européen des brevets

(19)

(11) Publication number: **0 424 249 A2**

# (12) EUROPEAN PATENT APPLICATION

(21) Application number: 90402906.3

(22) Date of filing: 16.10.90

(51) Int. Cl.5: **H03K 3/037**, H03K 3/356, H03K 5/153

(30) Priority: 16.10.89 JP 266112/89

(43) Date of publication of application:
24.04.91 Bulletin 91/17

(84) Designated Contracting States:
**DE FR GB**

(71) Applicant: **FUJITSU LIMITED**
**1015, Kamikodanaka Nakahara-ku**
**Kawasaki-shi Kanagawa 211(JP)**

(72) Inventor: **Tsuchimoto, Yuji**
**7652, Mukaishima-cho**
**Mitsugi-gun, Hirosima 722(JP)**

(74) Representative: **Joly, Jean-Jacques et al**
**CABINET BEAU DE LOMENIE 55, rue**
**d'Amsterdam**
**F-75008 Paris(FR)**

(54) **A trigger pulse generating circuit.**

(57) The circuit (1) detects a changeover in an input signal and generates a trigger pulse. Essential parts of the circuit are formed of MOS transistors. The circuit comprises a signal input portion, a trigger pulse output portion, a complementary signal generating unit (2) for generating complementary signals in response to an input signal supplied to the signal input portion, a two-input gate unit (NG) having input terminals (5,6) for receiving the complementary signals and an output terminal (10) connected to the trigger pulse output portion, and a delay unit (3,4) for delaying at least one of the complementary signals to be supplied to the input terminals of the two-input gate unit relative to the other by a predetermined delay time. The delay unit includes an adjusting circuit (12,13) comprising a bipolar transistor and a resistor.

*Fig. 3*

EP 0 424 249 A2

## A TRIGGER PULSE GENERATING CIRCUIT

BACKGROUND OF THE INVENTION

1. Field of the Invention

The present invention relates to a trigger pulse generating circuit disposed in a semiconductor integrated circuit, etc., to detect a changeover in an input signal and generate a trigger pulse.

2. Description of the Related Art

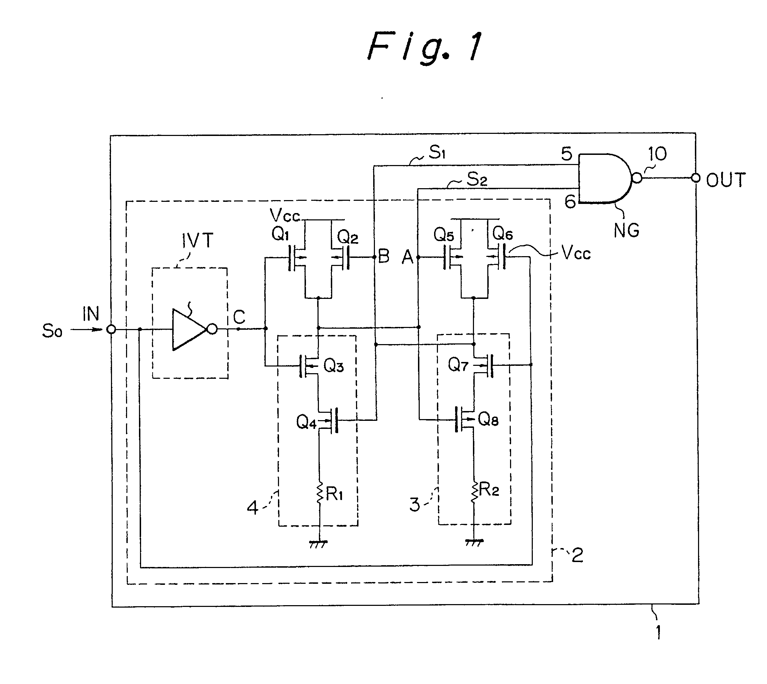

Figure 1 shows an example of conventional trigger pulse generating circuits.

In Fig. 1, trigger pulse generating circuit 1 has an input portion IN and an output portion OUT. A two-input NAND gate NG is disposed between the input and output portions. The two-input NAND gate NG has an output terminal connected to the output portion OUT, and input terminals 5 and 6. A signal processing circuit 2 is disposed between the NAND gate NG and the input portion IN to provide complementary signals S1 and S2 to the input terminals 5 and 6 of the NAND gate NG, respectively, in response to a changeover in an input signal. The signal processing circuit 2 includes circuits 3 and 4 to delay a drop in the signals S1 and S2 to be supplied to the input terminals 5 and 6 of the NAND gate NG.

The signal processing circuit 2 mainly comprises MOS transistors. Signal levels of the complementary input signals S1 and S2 to be supplied to the input terminals 5 and 6 of the NAND gate NG are determined by voltages at points A and B, respectively. The voltages at the points A and B change in response to an input signal supplied to the input portion IN. The input signal to the input portion IN is supplied, on the one hand, directly to MOS transistors Q6 and Q7, and on the other hand, to MOS transistors Q1 and Q3 via an inverter IVT.

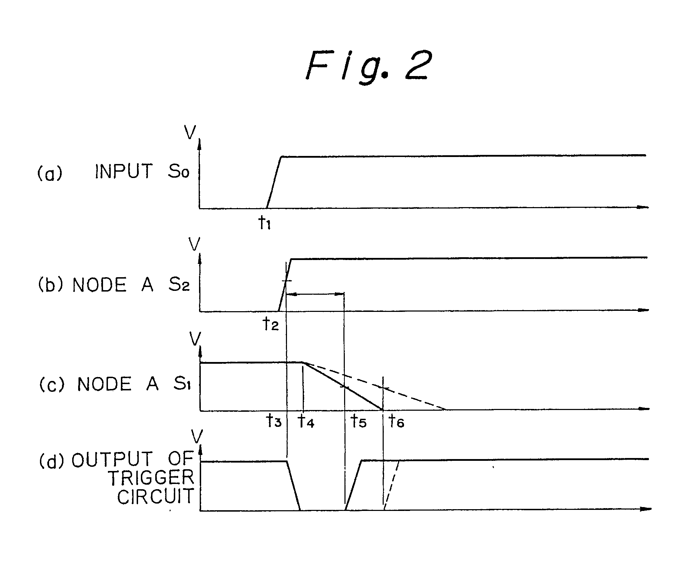

Supposing an input signal S0 to the input portion IN changes from LOW (L) to HIGH (H) at time t1 as shown in Fig. 2(a), a point C positioned at an output of the inverter IVT will be L. This turns ON the MOS transistor Q1 and turns OFF the MOS transistor Q3. As a result, a potential at the point A changes from L to H as shown in Fig. 2(b).

At this time, a MOS transistor Q5 is turned OFF, and a MOS transistor Q8 ON.

In the Meantime, the MOS transistor Q6 is turned OFF, and the MOS transistor Q7 is turned ON. Namely, the MOS transistors Q7 and Q8 are conductive, while the MOS transistors Q5 and Q6 are in an OFF state. As a result, a current flows from the point B through the MOS transistors Q7 and Q8 and a resistor R2 toward a ground GND, thereby decreasing the potential at the point B as shown in Fig. 2(c).

When the input signal S0 is inverted, opposite operations will take place to raise the potential of the point B and drop the potential of the point A.

In this way, the signal processing circuit 2 of the trigger pulse generating circuit 1 produces the two complementary signals S1 and S2, which are provided to the NAND gate NG. The NAND gate NG then generates a trigger pulse in response to levels of the signals S1 and S2. More precisely, each of the signals S1 and S2 to be provided to the NAND gate NG has a delay in a rise time (from L to H) and in a fall time (from H to L), wherein the fall time is longer than the rise time. Based on the difference of the delays, a trigger pulse is generated.

This will be explained in more detail. When the input signal S0 rises from L to H at time t1 in Fig. 2(a), a voltage at the point A, i.e., a voltage of the signal S2 changes from L to H at time t2 that is slightly delayed from the time t1 as shown in Fig. 2(b). A voltage at the point B, i.e., a voltage of the signal S1 starts to fall from H to L at time t4 as shown in Fig. 2(c). Generally, a threshold of the NAND gate NG is set to an H level, usually one half of Vcc. According to the threshold, an output of the NAND gate falls at the time t2 when the potential of the point A reaches 1/2 H. Also, the output of the NAND gate rises at the time t5 when the potential of the point B becomes 1/2 H or smaller. A time period td between the time t3 and the time t5 is used as the width of a trigger pulse.

In this way, the conventional trigger pulse generating circuit controls a fall time of one of the signals S1 and S2 to adjust the width of a trigger pulse. Supposing a fall waveform at the point B is as indicated with a dotted line in Fig. 2, the level of the signal S1 becomes 1/2 H, i.e., 1/2 Vcc at time t6, so that the width td of a trigger pulse may be extended. The fall times of signals to be supplied to the NAND gate NG are controlled by the adjusting circuits 3 and 4 of Fig. 1, and delays of the signals are controlled by optionally changing the values of internal resistance of the MOS transistors Q3, Q4, Q7, and Q8 as well as the resistance values of the resistors R1 and R2.

In this sort of conventional trigger pulse generating circuit, the adjusting circuits 3 and 4 involve the MOS transistors Q3, Q4, Q7, and Q8. Generally, the resistance of a MOS transistor changes depending on temperature. Even when the circuits 3 and 4 are designed to provide required delays, they may be affected by temperature change during use to fluctuate signal fall times at the points A and B, thereby changing the width of a trigger pulse. This may cause a malfunction.

Changes to occur in the internal resistance of MOS transistors of the conventional trigger pulse generating circuit will be studied in detail.

In Fig. 1, a time constant CR determines a signal fall time. A total resistance component (a component R) of the time constant CR is considered to be the internal resistance of the MOS transistor Q3 plus the internal resistance of MOS transistor Q4 plus the resistance of resistor R1, as well as the internal resistance of MOS transistor Q7 plus the internal resistance of MOS transistor Q8 plus the resistance of resistor R2. Here, a component C comprises the capacitance of respective MOS transistors, floating capacitance on wires, and capacitive components connected to the input and/or output side.

The internal resistance of a MOS transistor is intrinsically high. Since the trigger pulse generating circuit uses a plurality of MOS transistors, the internal resistance of the MOS transistors assumes a large proportion of the component R. The internal resistance of the MOS transistors is easily affected by temperature change at a rate of 0.3%deg to 0.4%/deg and by manufacturing unevenness which is rated at plus/minus 30%. In this way, the component R fluctuates in response to the manufacturing unevenness and temperature change, thereby causing the problems mentioned above.

Generally, the resistors R1 and R2 of Fig. 1 are diffused resistors formed on the circuit. Similar to the MOS transistors, the resistance of the resistors R1 and R2 change in response to the temperature change and manufacturing unevenness. Although the changes in the resistors R1 and R2 are small compared with those occurring in the internal resistance of the MOS transistors, they may be 0.2%/deg for the temperature change and about plus/minus 10% for the manufacturing unevenness.

Consequently, it is necessary to consider the internal resistance of the MOS transistors and the resistance of the diffused resistors as well as the variations of the respective resistors.

## SUMMARY OF THE INVENTION

As explained above, the conventional trigger pulse generating circuit includes the signal fall time adjusting circuits as an element for determining the width of a trigger pulse. The signal fall time adjusting circuits comprise MOS transistors having a large internal resistance which is easily affected by manufacturing unevenness and temperature change. In addition, the internal resistance of the MOS transistors assumes a large proportion of the total resistance of the signal fall time adjusting circuits, so that the total resistance may easily change to fluctuate the width of a trigger pulse, thereby deteriorating the reliability of the trigger pulse generating circuit.

To cope with the problem, an object of the present invention is to provide a trigger pulse generating circuit that can suppress a change occurring in the width of a trigger pulse due to a change in the internal resistance of MOS transistors that is caused by temperature change and manufacturing unevenness.

To achieve the object, the present invention provides a trigger pulse generating circuit for detecting a changeover in an input signal and generating a trigger pulse, comprising a signal input portion, a trigger pulse output portion, and a signal processing means disposed between the input portion and the trigger pulse output portion. The signal processing means comprises a complementary signal generating means for generating complementary signals in response to an input signal provided to the input portion; a two-input gate means having input terminals for receiving the complementary signals and an output terminal connected to the trigger pulse output portion; and a delay means disposed between the complementary signal generating means and the two-input gate means, for delaying at least one of the complementary signals to be provided to the two-input gate means relative to the other by a predetermined delay time. The signal processing means mainly comprises MOS transistors, and the delay means includes an adjusting circuit involving a bipolar transistor and a resistor.

According to the present invention, each of delay circuits 3 and 4 for delaying fall times or rise times of the complementary signals to be supplied to the two-input gate, e.g., a NAND gate, includes an adjusting circuit comprising a bipolar transistor having small internal resistance and a resistor that are connected to each other in series. With this arrangement, the fall times or the rise times of the signals to be supplied to the two-input gate are less affected by temperature change and manufacturing unevenness of the MOS transistors. As a result, the width of a trigger pulse will not fluctuate due to the temperature change, etc., thereby improving the reliability of the trigger pulse generating circuit.

## BRIEF DESCRIPTION OF THE DRAWINGS

Fig. 1 is a circuit diagram showing a conventional trigger pulse generating circuit;

Fig. 2 is a view showing waveforms of the conventional circuit and a circuit of the present invention;

Fig. 3 is a circuit diagram showing a trigger pulse generating circuit according to an embodiment of the present invention.

Fig. 4 is a circuit diagram showing an ATD circuit including ETG circuits; and

Fig. 5 is a circuit diagram showing one example of a memory circuit utilizing an ATD circuit.

## DESCRIPTION OF THE PREFERRED EMBODIMENTS

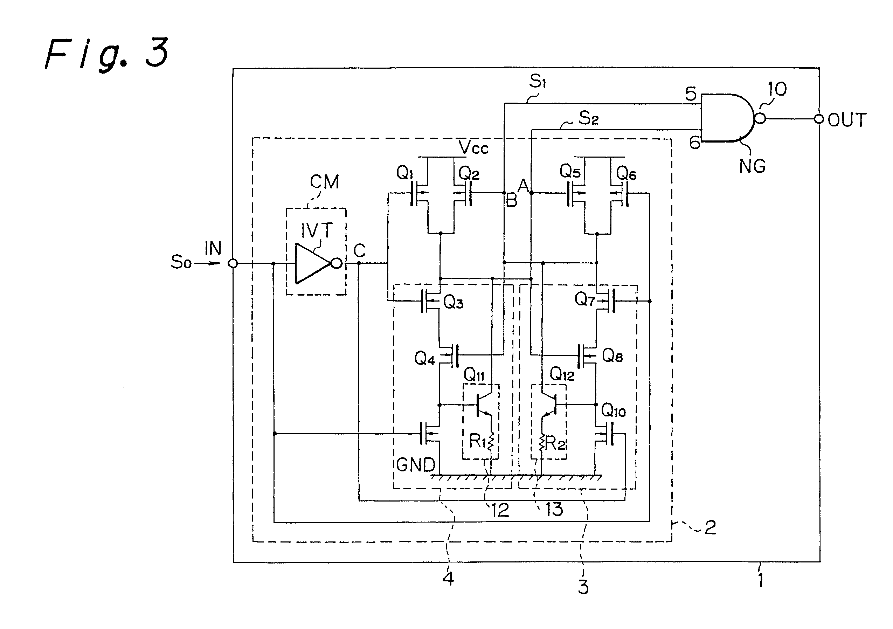

The embodiment of the present invention will be explained with reference to the drawings, starting with Fig. 3.

A trigger pulse generating circuit 1 of the present invention basically comprises a signal input portion IN, a trigger pulse output portion OUT, and a signal processing means 2 disposed between the signal input portion IN and the trigger pulse output portion OUT. The signal processing means 2 comprises a complementary signal generating means CM for generating complementary signals S1 and S2 in response to an input signal provided to the signal input portion IN, a two-input gate means NG having input terminals 5 and 6 for receiving the complementary signals S1 and S2, respectively, and an output terminal 10 connected to the trigger pulse output portion OUT, and delay means 3 and 4 disposed between the complementary signal generating means CM and the two-input gate means NG, for delaying at least one of the complementary signals S1 and S2 to be provided to the input terminals 5 and 6 of the two-input gate means NG relative to the other by a predetermined time period.

Essential parts of the signal processing means 2 comprise MOS transistors Q3, Q4, Q9, Q7, Q8, and Q10. The delay means 3 and 4 include adjusting circuits 12 and 13, respectively, that comprise bipolar transistors Q11 and Q12 and resistors R1 and R2.

In this basic configuration of the present invention, the complementary signal generating means CM comprises an inverter. Alternatively, the means CM may be any known complementary signal generating means.

According to the embodiment, the delay means 3 and 4 delay the rise times or the fall times of the complementary signals S1 and S2, respectively. According to the present invention, it is also allowed to delay the rise time or the fall time of at least one of the complementary signals S1 and S2. In this case, either one of the delay means 3 or 4 may be omitted.

In the above embodiment, the two-input gate means NG is a NAND gate. This gate means may also be a NOR gate.

An arrangement and operation of a concrete example of the trigger pulse generating circuit according to the present invention will be explained, still with reference to Fig. 3. This example includes delay circuits 3 and 4 that incorporate adjusting circuits 12 and 13, respectively.

A NAND gate NG is disposed between an input portion IN and a trigger pulse output portion OUT. The NAND gate NG has an output terminal connected to the trigger pulse output portion OUT. A signal processing circuit 2 is disposed between the NAND gate NG and the signal input portion IN, and connected to input terminals 5 and 6 of the NAND gate NG. The signal processing circuit 2 supplies a first signal to one of the input terminals 5 and 6 of the NAND gate NG, and a second signal to the other a predetermined time after the supply of the first signal.

An input signal S0 is supplied to the input portion IN and then to a gate of a MOS transistor Q9. The MOS transistor Q9 is one of three N-channel MOS transistors Q3, Q4, and Q9 that are connected in series on the drain side of a P-channel MOS transistor Q1. A source of the MOS transistor Q1 is connected to a high-voltage power source Vcc. The input signal S0 is also supplied to gates of MOS transistors Q6 and Q7, which are among N-channel MOS transistors Q7, Q8, and Q10 that are connected in series on the drain side of a P-channel MOS transistor Q6. The source of the MOS transistor Q6 is connected to the high-voltage power source Vcc.

Meanwhile, the input signal S0 is passed through an inverter IVT and supplied to gates of the MOS transistors Q1 and Q3 as well as a gate of the MOS transistor Q10.

P-channel MOS transistors Q2 and Q5 are disposed in parallel with the MOS transistors Q1 and Q6 and connected to the high-voltage power source Vcc and the sources of the MOS transistors Q3 and Q7. The gate of the P-channel MOS transistor Q2 forms a point B, which is connected to the input terminal 5 of the NAND gate NG. The point B is also connected to the gate of the MOS transistor Q4. The gate of the P-channel MOS transistor Q5 forms a point A, which is connected to the input terminal 6 of the NAND gate NG. The point A is also connected to the gate of the MOS transistor Q8.

The source of the MOS transistor Q3 is connected to the gate of the MOS transistor Q8. A node between the MOS transistors Q3 and Q8 is connected to the collector of a bipolar transistor Q11. The emitter of the bipolar transistor Q11 is grounded through a resistor R1, and the base thereof is connected to the source of the MOS transistor Q9.

The source of the MOS transistor Q7 is connected to the gate of the MQS transistor Q4. A node between the MOS transistors Q7 and Q4 is connected to the collector of a bipolar transistor Q12. The emitter of the bipolar transistor Q12 is grounded through a resistor R2, and the base thereof is connected to the source of the MOS transistor Q10. Drains of the MOS transistors Q9 and Q10 are grounded.

In the signal processing circuit 2, the MOS transistors Q3, Q4 and Q9, bipolar transistor Q11, and resistor R1 form the delay adjusting circuit 4. The MOS transistors Q7, Q8 and Q10, bipolar transistor Q12, and resistor R2 form the delay adjusting circuit 3.

In the above embodiment, the bipolar transistors are NPN transistors. According to the present invention, they may be PNP transistors, if they match other parts of the circuit.

The operation of the embodiment will be explained next. The input signal S0 changes from L (LOW) to H (HIGH) at time t2 of Fig. 2(a). A voltage at a point C positioned at an output of the inverter IVT then changes from H to L. This turns ON the MOS transistor Q1 and OFF the MOS transistor Q3. Accordingly, the point A rises from L to H as shown in Fig. 2(b). At this time, the MOS transistor Q10 is turned OFF.

The input signal S0 not passing through the inverter IVT turns OFF the MOS transistor Q7 and ON the MOS transistor Q7. At this time, the MOS transistor Q5 is in an OFF state because the point A has risen. The MOS transistor Q8 is turned ON due to the rise of the point A. Since the MOS transistor Q10 is turned OFF, the source of the MOS transistor Q10, i.e., the base of the bipolar transistor Q12 is set to H to turn ON the bipolar transistor Q12. As a result, a large amount of current flows from the point B through the bipolar transistor Q12 and resistor R2 toward the ground, thereby dropping the potential of the point B as shown in Fig. 2(c). A delay time of the fall of the point B can be determined by properly selecting a resistance value of the resistor R2 because the internal resistance of the bipolar transistor Q12 is very small.

The input signal S0 not passing the inverter IVT is also supplied to the gate of the MOS transistor Q9 to turn ON the same. The potential of the source of the transistor Q9 then decreases to turn OFF the bipolar transistor Q11.

When the input signal S0 changes from H to L, opposite operations will take place to drop the voltage at the point A with a delay that is determined by the transistors and resistor of the delay adjusting circuit 4, and raise the voltage of the point B in a short time.

An advantage of employing the bipolar transistors Q11 and Q12 for the adjusting circuits 12 and 13 of the delay circuits 3 and 4 will be explained next.

If the delay circuits are formed of MOS transistors and resistors as in the case of the conventional technique, respective resistance values in the delay circuits are affected by manufacturing unevenness of the transistors and resistors and by temperature change. This fluctuates a total resistance value R of the delay circuits, thereby influencing the width of a trigger pulse. The MOS transistors have large manufacturing unevenness, temperature dependency, and internal resistance values. The internal resistance of the MOS transistors assumes a large proportion of the total resistance R to greatly fluctuate the total resistance R.

It is necessary to consider a rate of change of the resistance values of the diffused resistors and the internal resistance of the MOS transistors due to the manufacturing unevenness and temperature change. It is also necessary to consider setting the pulse width td of Fig. 2 to a minimum value or greater.

According to the conventional delay circuit formed only of MOS transistors and diffused resistors, a maximum resistance value will be 2.4 at 100 degrees centigrade relative to a required optimum total resistance value R which is supposed to be 1 at zero degrees centigrade. In this way, a large change occurs in the resistance value of the conventional circuit. Namely, the resistance value of the conventional circuit changes 2.4 times between zero and 100 degrees centigrade.

To quickly switch an output signal, it is necessary to discharge capacitance C. To achieve this, the capacitance C must be small. If the size of each MOS transistor is reduced to reduce the capacitance C, however, a driving capacity of the transistor is also reduced. Then, the number of the transistors must be increased, thereby increasing the total resistance R.

According to the present invention, each of the delay circuits includes an adjusting circuit formed of a bipolar transistor and a diffused resistor, and a current is designed to mainly pass through the adjusting circuit. The total resistance R in the constant RC of the delay circuit of the present invention will be a sum of the internal resistance of the bipolar transistor and the resistance of the diffused resistor.

The bipolar transistor has a large driving capacity and small internal resistance compared with those of the MOS transistor. On the other hand, the temperature dependency of the internal resistance of the bipolar transistor is similar to that of the MOS transistor, while manufacturing unevenness of the bipolar transistor is smaller than that of the MOS transistor.

Since the bipolar transistor has a large driving capacity, the number of bipolar transistors employed by the present invention is smaller than that of the MOS transistors employed by the conventional technique. Since the bipolar transistor has small internal resistance, it occupies a small area in the delay circuit.

Even when the internal resistance of the bipolar transistor is changed due to temperature change, the total resistance R is not substantially affected, because the internal resistance of the bipolar transistor assumes only a small proportion of the total resistance R.

According to the present invention, the total resistance R of the delay circuit will be about 1.4 at 100 degrees centigrade relative to 1 at zero degrees centigrade.

The delay circuits 3 and 4 of the present embodiment involve, as their essential elements, the bipolar transistors Q11 and Q12 each having a very small internal resistance compared with that of the MOS transistor. The internal resistance of the bipolar transistors assumes, therefore, a small proportion of the total resistance R. This can prevent the width of a trigger pulse provided by the NAND gate NG from being affected by temperature change. The MOS transistors Q9 and Q10 employed by the embodiment provide switching actions on the bipolar transistors Q11 and Q12.

An example of applications of the trigger pulse generating circuit according to the present invention will be explained next.

The trigger pulse generating circuit according to the present invention may be employed in an ATD (Address Transition Detector) circuit.

The ATD circuit is a circuit for generating a clock pulse in response to a detection of a change of an address signal and for contributing to a high speed operation and a reduction of power consumptions in a circuit device.

In the ATD circuit, when a number of input address signals is large, a problem arises in that an output signal is sometimes delayed.

Accordingly, each edge trigger circuit (ETG) provided in the ATD circuit is required to operate in high speed and to generate pulses having a constant pulse delay or pulse width regardless of a variation caused by a temperature change or a factor in a manufacturing process thereof.

Therefore, the trigger pulse generating circuit of the present invention is suitable circuit to be used in the edge trigger circuit for an ATD circuit.

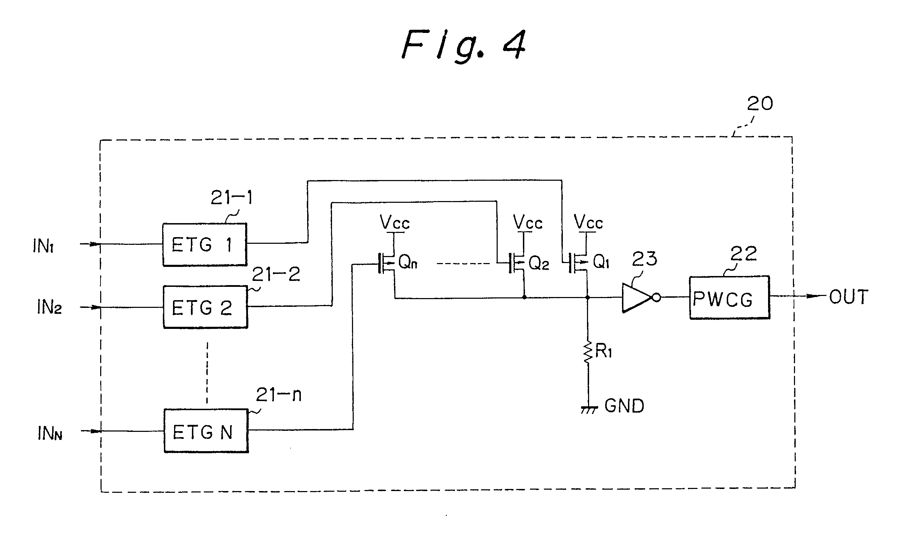

Figure 4 shows one example of a construction of an ATD circuit utilizing a trigger pulse generating circuit of the present invention as an edge trigger circuit.

In that, an ATD circuit 20 comprises a plurality of address inputs IN1 to INn, a plurality of edge trigger circuits 21-1 to 21-n corresponding to each one of the address inputs IN1 to INn, a plurality of PMOS transistors Q1 to Qn, an inverter 23 and a pulse width controlling circuit (PWCG) 22.

Each of the outputs of each one of the edge trigger circuits 21-1 to 21-n is connected to a gate of each of the PMOS transistors Q1 to Qn while a source of each one of the PMOS transistors is connected to an output of the ATD circuit 20 through the inverter 23 and the pulse width controlling circuit (PWCG) 22.

As explained above, the trigger pulse generating circuit of the present invention is used for each one of the edge trigger circuits 21-1 to 21-n respectively, in the ATD circuit 20.

The ATD circuit 20 as shown in Fig. 4, can be preferably used with an address circuit in a memory circuit in a semiconductor integrated circuit in which information are read out from and written into each one of memory cells in the memory circuit.

Note, that generally, the ATD circuit selects one bit line in a memory and raises a voltage of the bit line to an H (HIGH) level. Bit lines that are not selected in the memory are usually at an L (LOW) level. It is required to charge the selected bit line up to the H level as quickly as possible.

To shorten a time period for raising the selected bit line from the non-selected L level to the H level, the ATD circuit detects in advance that an address has been changed, and, for example, raises the voltage level of the selected bit line to an intermediate level between the L and H levels or reduces it to a voltage level close to a ground level, thereby shortening a rise time of the selected bit line or preventing erroneous operation when the output signal level is changed from H level to L level. This sort of ATD circuit can employ the present invention as a means for detecting whether or not the address has been changed.

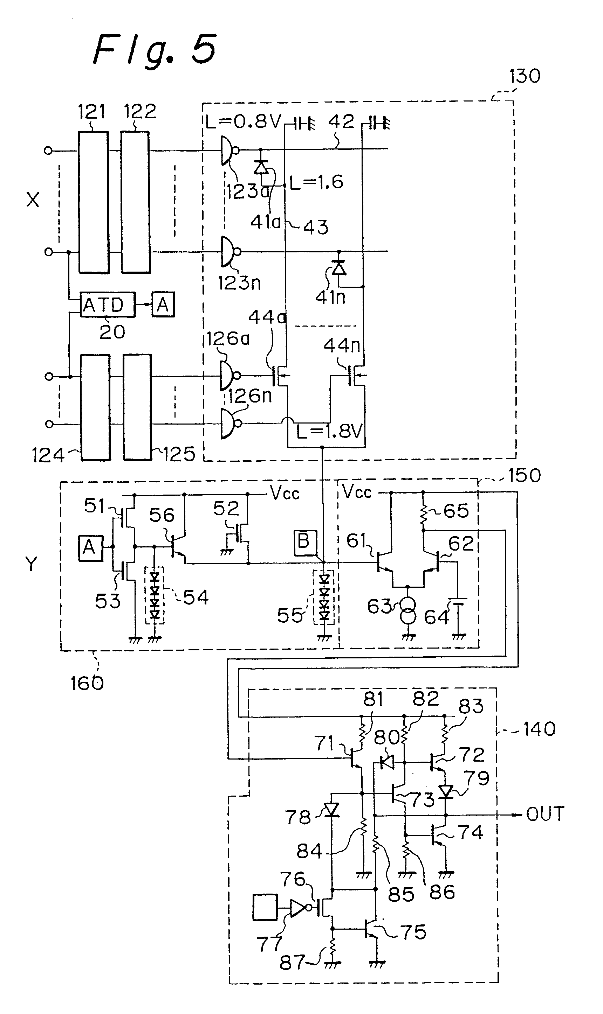

Figure 5 shows one example of a semiconductor memory circuit utilizing a ATD circuit including the trigger pulse generating circuit of the present invention.

Fig. 5 is the semiconductor memory circuit including a PROM circuit as a memory cell 130.

In that, the memory circuit comprises an address buffer 121 for X direction, a decoder 122, a plurality of word drivers 123a to 123n each of which consists of a Bi-CMOS, an address buffer 124 for Y direction, a decoder 125, a plurality of bit drivers 126a to 126n, an ATD circuit 20, a memory cell portion 130, a signal compensating circuit 160, a sense amplifier 150 and an output circuit 140.

In this circuit, the ATD circuit 20 detects a change of each one of the address signals and generates an ATD pulse, i.e., an inner pulse which is transmitted to the signal compensating circuit 160 and the output circuit 140.

On the other hand, the memory cell portion 130 comprises a plurality of cell diodes 41a to 41n, a plurality of word lines 42-1 to 42-n, a plurality of bit lines 43-1 to 43-n and a plurality of bit-switching transistors 44a to 44n.

The signal compensating circuit 160 comprises PMOS transistors 51 and 52, an NMOS transistor 53, clamp diodes 54 and 55 and a bipolar transistor 56.

The signal compensating circuit 160 compensates a level of a logic signal with a clamping circuit in response to an ATD pulse.

While, the sense amplifier 150 comprises transistors 61 and 62 both of which constitute a differential amplifier, an electric current source 63, a reference source 64 and a resistor 65.

In that, a voltage of the reference voltage source is, for example, 2.4 V.

And in the sense amplifier 150, an information generated from the memory cell portion 130 is amplified and is transferred to the output circuit 140.

In the output circuit 140 comprised Schottky transistors 71 to 74, a conventional transistor 75, an NMOS transistor 76, an inverter 77, Schottky diodes 78 and 79, a conventional diode 80 and resistors.

Accordingly, the output circuit 140 keeps the output terminal OUT in a high impedance with respect to an output date when the ATD pulse is input thereto.

And the output circuit 140 gradually draws an current flown in this circuit to the ground under the high impedance condition so that a potential level of the output terminal is reduced smoothly.

When the input of the ATD pulse is stopped, the potential level of the output terminal is changed to any one of H level and L level in response to the output level of the sense amplifier 150, from the level of the output terminal caused by the operation by which the current is drawn to the ground.

In this example, high level of power source Vcc may be, for example, 5 V while low level of power source may be ground, i.e., 0 V.

One example of an operation of the memory circuit as shown in Fig. 5 will be explained, hereunder.

When an address signal is defined, it is input to the address buffers 121 and 124 and simultaneously input to the ATD circuit 20.

Thereby, the ATD circuit 20 outputs an ATD pulse (which is active in L level) to transfer to the signal compensating circuit 160 and the output circuit 140 at a point as shown in Fig. 5.

When the ATD pulse is input to the signal compensating circuit 160, in the circuit 160, the bipolar transistor 56 is turned ON thereby an emitter-follower circuit, the base of which is clamped at a predetermined level from the ground, starts to operate to raise a potential level of its emitter voltage upto 2.4 V.

On the other hand, since a current i is flowes into a node point B from a high voltage source Vcc through the PMOS transistor 52, a potential level at the node B is immediately pulled upto 3.2 V and clamped at same level.

While, in the output circuit 140, since a NMOS transistor 76 is turned ON in response to the ATD pulse, the transistor 75 is turned ON thereby both of the Schottky transistors 72 and 73 are turned OFF reducing the Schottky transistors 74 to OFF.

Accordingly, the output terminal OUT is placed in a high impedance condition.

In this situation, the current flown in the output circuit, is gradually drawn to the ground due to the transistor 75 having a small driving performance being turned ON, so that the potential level of the output terminal is smoothly reduced and thus the level of the output terminal is reduced to have substantially the same potential level as the ground level.

After that, when the output of the ATD pulse is stopped, the high impedance condition in the output terminal is eliminated and the potential level of the output terminal is set at a level defined by an output level of the sense amplifier circuit 150.

At this time, the level of the node B is turned to H level or L level depending upon an information stored in a selected memory cell in the memory cell portion 130.

The potential level of the node B is read by the sense amplifier 150 and transferred to the output circuit 140.

Accordingly, when an output data is changed from H level to L level, for example, the potential level of the output terminal can be immediately changed from a condition which is substantially the same level as the ground level to L level.

On the other hand, when an output data is changed from L level to H level, for example, the potential level of the output terminal can also be immediately changed from a condition which is substantially the same level as the ground level to H level.

As explained above, in the memory circuit, when the ATD pulse is output, the current flown through the output circuit is drawn to the ground so that the output terminal has substantially the same potential level as the ground level and further the reduction of the potential level can be carried out gradually so as not to give a noise source to a ground terminal of a device.

Accordingly, even when an amount of an external load $C_1$ is large and a parasitic inductance $L_{Vcc}$ and resistances $R_{Vcc}$ exist therein, a problem can be prevented in which a ground potential level of an inner circuit or the like is raised due to an absorption current and thus these parasitic inductance $L_{Vcc}$ and resistances $R_{Vcc}$ is prevented from adversely affecting an input signal as a noise source.

Therefore, this memory circuit can make the output stable and prevent from operating erroneously.

## Claims

1. A trigger pulse generating circuit for detecting a changeover in an input signal and generating a trigger pulse, having a signal input portion, a trigger pulse output portion, and a signal processing means disposed between said signal input portion and trigger pulse output portion, said signal processing means having:
a complementary signal generating means for generating complementary signals in response to an input signal provided to said signal input portion;
a two-input gate means having input terminals for receiving said complementary signals, and an output terminal connected to said trigger pulse output portion; and
a delay means disposed between said complementary signal generating means and said two-input gate means, for delaying at least one of said complementary signals to be supplied to the input terminals of said two-input gate means relative to the other by a predetermined delay time, said circuit being characterized in that,
said delay means includes an adjusting circuit comprising a bipolar transistor and a resistor, serially arranged each other and provided between an input of said two-input gate means and a lower potential source.

2. A trigger pulse generating circuit as set forth in claim 1, wherein said delay means acts separately on said complementary signals.

3. A trigger pulse generating circuit as set forth in claim 1, wherein said delay means has a function of delaying at least one of a rise time and a fall time of any one of said complementary signals.

4. A trigger pulse generating circuit as set forth in claim 1, wherein said two-input gate means comprises one of a NAND gate and a NOR gate.

5. A trigger pulse generating circuit for detecting a changeover in an input signal and generating a trigger pulse, having a signal input portion, a trigger pulse output portion, a two-input gate portion whose output terminal is connected to said trigger pulse output portion, and a signal processing circuit disposed between said two-input gate portion and said signal input portion,
said signal processing circuit providing a first signal to a first input terminal of said two-input gate portion and a second signal to a second input terminal of said two-input gate portion a predetermined time period after the supply of said first signal in response to a changeover detected in an input signal supplied to said signal input portion,
said signal processing circuit including a circuit for delaying said second signal to be supplied to said second input terminal of said two-input gate portion relative to said first signal, said circuit is characterized in that,
said circuit connected to said second input terminal of said two-input gate portion and delaying the supply of said second input signal to said two-input gate portion includes an adjusting circuit comprising a bipolar transistor and a resistor serially arranged each other and provided between said input of said two-input gate means and a lower potential source.

6. A trigger pulse generating circuit as set forth in claim 5, wherein said signal processing circuit includes:
a complementary signal generating means for generating complementary signals in response to an input signal supplied to said signal input portion;
a first differential amplifying circuit having first and second MOS transistors facing each other, one of said complementary signals generated by said complementary signal generating means being applied to a gate of said first MOS transistor, a gate of said second MOS transistor being connected to one of said input terminals of said two-input gate portion;
a second differential amplifying circuit having fifth and sixth MOS transistors facing each other, the other of said complementary signals generated by said complementary signal generating means being applied to a gate of said sixth MOS transistor, a gate of said fifth MOS transistor being connected to the other of said input terminals of said two-input gate portion; and
a delay time generating circuit, wherein said delay time generating circuit includes:
a first delay time generating circuit having third, fourth, and ninth MOS transistors arranged in series in this order, an end of said third MOS transistor being connected to an emitter portion of said first differential amplifying circuit, a gate of said third MOS transistor being connected to a gate of said first MOS transistor, a gate of said fourth MOS transistor being connected to a gate of said second MOS transistor and to an emitter portion of said second differential amplifying circuit, the other end of said ninth MOS transistor being connected to a low-voltage power source, a gate of said ninth MOS transistor being connected to a gate of said sixth MOS transistor, said first delay time generating circuit further having a first bipolar transistor, a base of said first bipolar transistor being connected to a node between said fourth and ninth MOS transistors, a collector of said first bipolar transistor being connected to said emitter portion of said first differential amplifying circuit, an emitter of said first bipolar transistor being connected to a low-voltage power source through a resistor; and

a second delay time generating circuit having seventh, eighth, and tenth MOS transistors arranged in series in this order, an end of said seventh MOS transistor being connected to said emitter portion of said second differential amplifying circuit, a gate of said seventh MOS transistor being connected to a gate of said sixth MOS transistor, a gate of said eighth MOS transistor being connected to a gate of said fifth MOS transistor and to said emitter portion of said first differential amplifying circuit, the other end of said tenth MOS transistor being connected to a low-voltage power source, a gate of said tenth MOS transistor being connected to a gate of said first MOS transistor, said second delay time generating circuit further having a second bipolar transistor, a base of said second bipolar transistor being connected to a node between said eighth and tenth MOS transistors, a collector of said second bipolar transistor being connected to said emitter portion of said second differential amplifying circuit, an emitter of said second bipolar transistor being connected to a low-voltage power source through a resistor, and wherein said first and second bipolar transistors cooperate with said resistors connected to their emitters, thereby forming adjusting circuits.

Fig. 1

EP 0 424 249 A2

Fig. 2

(a)  INPUT S₀

(b) NODE A S₂

(c) NODE A S₁

(d) OUTPUT OF TRIGGER CIRCUIT

t₁  t₂  t₃  t₄  t₅  t₆

EP 0 424 249 A2

# Fig. 3

# Fig. 4

EP 0 424 249 A2

# Fig. 5